Europäisches Patentamt

European Patent Office

Office européen des brevets

(11) Publication number: **0 129 751**
**B1**

(12) **EUROPEAN PATENT SPECIFICATION**

(45) Date of publication of patent specification: **17.11.88**

(51) Int. Cl.⁴: **G 01 N 21/88**

(21) Application number: **84106502.2**

(22) Date of filing: **07.06.84**

(54) Method and apparatus for inspecting a photomask reticle for semiconductor device fabrication.

(30) Priority: **23.06.83 JP 113230/83**

(43) Date of publication of application:
**02.01.85 Bulletin 85/01**

(45) Publication of the grant of the patent:
**17.11.88 Bulletin 88/46**

(84) Designated Contracting States:
**DE FR GB**

(56) References cited:
**GB-A-2 129 547**

**REVIEW OF THE ELECTRICAL COMMUNICATIONS LABORATORIES, vol. 30, no. 6, 1982, pages 1076-1085, Tokyo, JP; B. TSUJIYAMA et al.: "An automated mask defect inspection"**

(73) Proprietor: **FUJITSU LIMITED**
**1015, Kamikodanaka Nakahara-ku**
**Kawasaki-shi Kanagawa 211 (JP)**

(72) Inventor: **Matsui, Shogo**
**6-9-33, Sobudaidanchi 1-chome**
**Sagamihara-shi Kanagawa, 228 (JP)**
Inventor: **Kobayashi, Kenichi**
**34-3, Nagasaki 6-chome**
**Toshima-ku Tokyo, 171 (JP)**

(74) Representative: **Seeger, Wolfgang, Dipl.-Phys.**
**SEEGER & SEEGER Patentanwälte & European**
**Patent Attorneys Gottfried-Böhm-Ring 27**
**D-8000 München 70 (DE)**

Courier Press, Leamington Spa, England.

## Description

The present invention relates to an inspecting method of a photomask reticle used in the fabrication of a semiconductor device. More specifically, this invention relates to an inspection method of a photomask reticle for a large scale integrated circuit (LSI) or very large scale integrated circuit (VLSI), with inspection data stored in a medium such as a magnetic tape being called a database inspection method.

Recently, according to a tremendously high packing density of the semiconductor device, the photomask pattern is becoming dazzlingly complex and microscopic. As the photomask reticle corresponds to a mother pattern for fabricating the semiconductor device, it is one of the most important matters to keep excellent quality of the reticle; a defect of the pattern, though it is very microscopic, can not be allowed to exist.

In a LSI or VLSI semiconductor die, usually, plenty of semiconductor elements having a same pattern are fabricated. Therefore, the inspection of the photomask reticle was made at first visually by the human eye using a microscope comparing with an adjacent same pattern. This visual inspection took place by a "pattern comparing inspection" which is an automatic optically comparing inspection using an image sensor like a charge couple device (CCD) camera and an electronic circuit comparing the image.

However, recently, the pattern of the die has become so very complicated that it becomes difficult to inspect correctly by only the pattern comparing inspection method. Further, as the pattern comparing inspection requires a standard pattern for the comparison, if the standard pattern has a defect, the whole inspection would cause failure. Furthermore, if the die is composed of only a single pattern which does not have a same shape and size, the mask comparing inspection can not be applied. On the other hand, the design method of the reticle pattern by computer technique like a CAD (computer aided design) system using a "designing data-base" has been developed. Consequently, the concept of the CAD system has been introduced to the inspection so that the inspection comes to be made by an "inspection database" which is called as a "database inspection".

At the beginning of the database inspection, the designing data was used for the database inspection, but lately the "inspection database" is made for itself, in order to make the inspection process easy and to avoid the overlapped faults in the fabrication and inspection. Applying the database inspection method, the accuracy of the inspection goes up very high.

The database inspection can be made by an apparatus being called "reticle tester" in which the inspection data for the reticle pattern is stored in a store medium such as a magnetic tape. However, the volume of the inspection data becomes enormous because of too much complexity and too many kinds of the recent semiconductor device, so that keeping a space to stock the store media becomes almost impossible and the inspection comes to require plenty of time. These are becoming a big problem for the photomask reticle inspection, though the database inspection is needed to keep the very high accuracy.

## SUMMARY OF THE INVENTION

Therefore, the object of the present invention is to save the space for stocking the inspection data media, and the time to perform the inspection, applying substantially the database inspection method to keep the high accuracy of the inspection. The method of the present invention which is set out in claim 1 can be performed combining the method of the database inspection and the mask comparing inspection so that the latter method is applied to the reticle patterns each having a same shape and size in the photomask reticle. The invention also relates to an apparatus for inspecting a photomask reticle as set out in claim 6.

Applying the present invention to the inspection of the photomask reticle, the high accuracy of the inspection can be kept by the former method, the space of the database and the time to inspect can be saved by the later method.

## BRIEF DESCRIPTION OF THE DRAWINGS

Fig. 1 is a schematic plan view of the reticle pattern to be inspected.

Fig. 2 shows a block diagram of the prior art reticle tester.

Fig. 3 shows a schematic plan view of a reticle having a same pattern of Fig. 1 but for illustrating the present invention.

Fig. 4 shows a block diagram of a reticle tester for the present invention.

Fig. 5 shows a wave form chart illustrating the function of the reticle tester for the present invention. In Fig. 5:

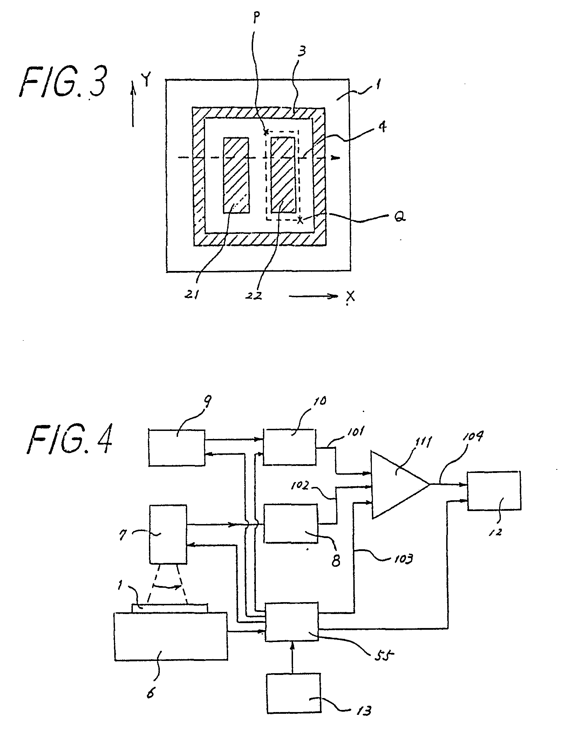

(a) is the scanning part of Fig. 3 being enlarged to make it correspond the following wave forms;

(b) is the wave form of the output from first wave shaping circuit 8 (at connecting line 101) in Fig. 4;

(c) is the wave form of the output from second wave shaping circuit 10 (at connecting line 102) in Fig. 4;

(d) is the wave form of the output from control unit 55 (at connecting line 103) in Fig. 4; and

(e) is the wave form of the output from comparator 111 (at connecting line 104) in Fig. 4.

## DETAILED DESCRIPTION OF THE INVENTION

Before disclosing the present invention, the method of the database inspection by means of a reticle tester of the prior art will be explained, because the reticle tester was a typical means used in the database inspection of the prior art and the present invention also relates to the improvement of the reticle tester.

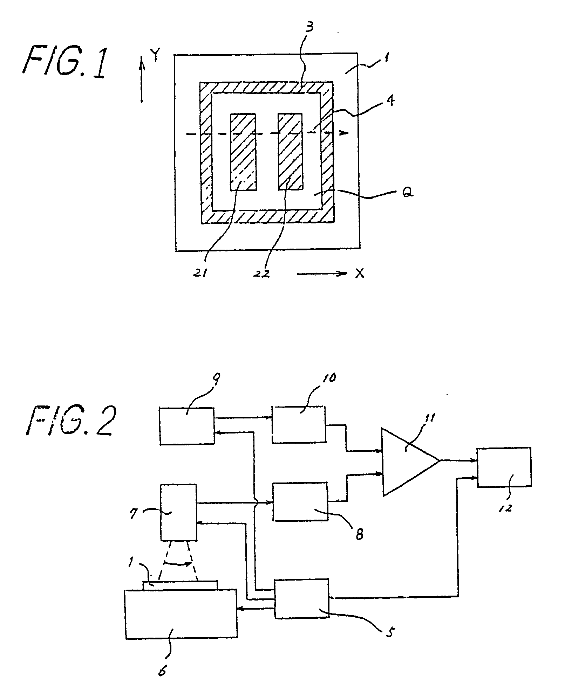

Fig. 1 shows illustratively a plan view of the reticle pattern to be inspected. In practical reticles, the pattern is more complicated than the one shown in Fig. 1 in which only small number of retangular patterns are shown for the sake of explanation. In the figure, reference numeral 1 is a reticle, reference numeral 21, 22, and 3 are the patterns on reticle 1. The patterns are printed on an optically transparent material with an opaque film, and are shown by simplified patterns for the sake of explanation so that pattern 21 and 22 are arranged parallel with the same shape and size being surrounded by pattern 3. Reference numeral 4 shows an optical scanning line for the database inspection of reticle 1, which scans optically the surface of the reticle from left to right in the figure along the X axis.

Fig. 2 shows a block diagram of the prior art reticle tester. In the figure, each unit or circuit operates as follows:

reference numeral 1 is a reticle which is the same as in Fig. 1 placed on the X—Y stage explained later;

reference numeral 5 is a control unit which outputs several control signals for the operation of the reticle tester;

reference numeral 6 is a X—Y stage on which reticle 1 is placed to be inspected and is scanned in a Y axis direction by precise mechanism from up to down in Fig. 1 being controlled by the control signal from control unit 5;

reference numeral 7 is a camera with which reticle 1 is scanned in a X axis direction synchronizing with the control signal from control unit 5, and camera 7 outputs electronic video signals corresponding the scanning of camera 7 and X—Y stage 6;

reference numeral 9 is a data store unit which stores the inspection data in the store media such as magnetic tapes and outputs the data video signals in cooperation with the scans of camera 7 and X—Y stage 6 being controlled by the control signal from control unit 5;

reference numeral 10 is a first wave shaping circuit which shapes the output from data store unit 9 to provide 'data video signals" for comparator 11 having a designated amplitude;

reference numeral 8 is a second wave shaping circuit which shapes the output from camera 7 to provide "optical video signals" for comparator 11 having the same amplitude as the designated amplitude of the data video signals from wave shaping circuit 8 unless the defect of the scanned pattern;

reference numeral 11 is a comparator which compares the data video signals and the optical video signals. Both signals go into comparator 11 with a same timing controlled by control unit 5, and the comparison is also made by a control signal from control unit 5. When the amplitude of the data video signals and the optical video signals are equal, that is, the pattern has no defect, comparator 11 will provide no output, but if the pattern has a defect, comparator 11 outputs a fault signal; and

reference numeral 12 is a memory which memorizes the fault signals in the address of the memory corresponding the pattern of the photomask reticle by the control signal from control unit 5.

The fault signals in memory 12 can be obtained visually on a video display or a printed paper on which the result of the inspection can be checked. From the result, the defect can be restored if it is possible, and the fault data can be accumulated for the quality control of the semiconductor device fabrication.

Fig. 1 shows a simple reticle pattern as an example, so there is not the problem of the volume for the data applying even the prior art reticle tester. However, as mentioned before, recent reticle patterns have become so very complicated that a very large store space for the data comes to be required. Therefore, the database inspection using the prior art reticle tester has become almost impossible to be applied to larger scale integrated circuit any more.

However, the semiconductor device having the high packing density is generally composed of plurality of the elements each having a same pattern, so the reticle also has plurality of the same shapes and size. The present invention is derived from this fact. That is, the patterns each having a same shape and size need not to be inspected individually; only one pattern is enough to be inspected by the database inspection method. If the patterns each having a same shape and size can be neglected from the database inspection, the stock space for the store media could be reduced very much. This can be achieved as follows: picking up one pattern from the patterns each having a same shape and size, the reticle tester inspects the picked up pattern by the database inspection method; then, the other remained patterns are inspected by the usual pattern comparing inspection method, setting the picked up pattern as a standard pattern to compare with.

As explained above, applying both methods the data base inspection and the pattern comparing inspection, the problem of the prior art can be solved, because the data of the patterns each having a same shape and size is not necessary to be stored, and still the inspection accuracy can be kept high. This is a point of the present invention; that is, the present invention requires only one pattern of the inspecting data for the patterns each having a same shape and size to the database inspection, and the other remaining patterns each having a same shape and size are inspected quickly by the pattern comparing inspection.

Fig. 3 shows a plan view of a reticle having the same shape and size as that of Fig. 1 for illustrating the present invention. In the figure, reference numerals or symbols are the same as in Fig. 1 except P and Q. Symbol P and Q are the points of the X—Y coordinates which designate an excluding region P—Q; a dotted square sieve including pattern 22 having the same pattern as pattern 21.

When pattern 21 has been inspected previously by the database inspection, and the pattern comparing inspection method is applied to the region P—Q comparing pattern 22 to pattern 21, the patterns within the region P—Q can be excluded from the object of the database inspection. Such region P—Q will be called as "excluding region" hereinafter. By doing this, the data for the database inspection, that is, the space for stocking the magnetic tapes can be reduced, and time for the inspection can be saved very much.

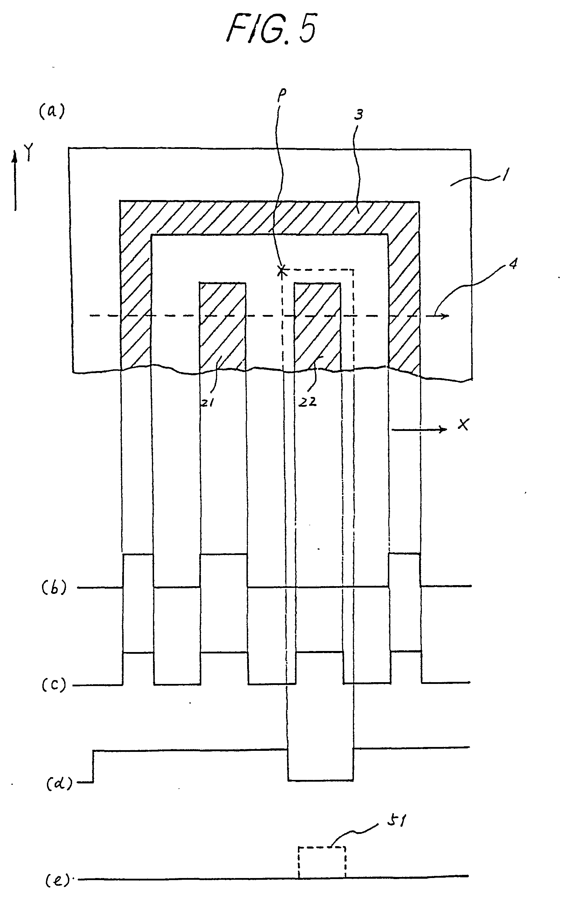

Fig. 4 shows a block diagram of an apparatus (a reticle tester) of the present invention, and Fig. 5 shows a wave form chart illustrating the function of the reticle tester of the present invention how to exclude the patterns each having a same shape and size from the object of the database inspection.

In Fig. 4, each block having the same reference numeral as in Fig. 2 has the same function also. Reference numeral 13 is a "region setter" which sets the excluding regions such as excluding region P—Q in Fig. 3 to exclude the database inspection of the patterns within the excluding region such as pattern 22 in Fig. 3. Control unit 55 and comparator 111 have the similar function to control unit 5 and comparator 11 in Fig. 2 respectively, but are modified to set the excluding regions.

Fig. 5(a) shows a scanning part of Fig. 3 being enlarged to correspond the following wave forms. Fig. 5(b), (c), (d), and (3) show the wave forms at the lines of reference numeral 101, 102, 103, and 104 in the block diagram respectively when the optical scanning is made on reticle 1 as shown in Fig. 5(a).

At the beginning of the reticle inspection, the groups of the patterns each having a same shape and size are selected from the designing data of the reticle patterns, a group including pattern 21 and 22 in Fig. 3 for example, and a pattern is picked up from each group; pattern 21 in Fig. 3 for example. And the address information of the excluding regions, P and Q in Fig. 3 for example, from the designing data are set to the control unit 55 by an inspector to exclude the excluding regions from the object of the database inspection. The picked up pattern is inspected by the database inspection method and is also used as the standard pattern for the pattern comparing inspection.

In the Fig. 4, when the addresses of P and Q are given to region setter 13 by the inspector, the region setter 13 controls the control unit 55 to designate the excluding regions such as excluding region P—Q in Fig. 3 or Fig. 5(a). In Fig. 5(a) only P is indicated. When camera 7 scans the reticle 1 such as optical scanning line 4 in Fig. 3 or Fig. 5(a), control unit 55 controls a first shaping wave circuit 8 so that the data video signal at line 101 goes to comparator 111 removing pattern 22 in excluding region P—Q as shown in Fig. 5(b). Meanwhile, the camera video signal goes into comparator 111 in a wave form at line 102 as shown in Fig. 5(c). Comparator 111 compares wave form (b) and (c) during the time interval so long as "on" signal is applied to the line 103 from control unit 55 as shown in Fig. 5(d), so that the output signal from comparator 111 at line 104 has no fault information as shown in Fig. 5(e). If there was not the gate signal, comparator 111 would provide a fault signal as shown a dotted wave form 51 in Fig. 5(e). The fault signals from comparator 111 go into memory 12 if there are some defects on the reticle pattern and are memorized in each address under the control by control unit 55. The result of the inspection can be checked by the judge signals from memory 12 as mentioned before.

After pattern 21 has been judged to be correct by above data base inspection, the pattern in the excluding region such as pattern 22 can be inspected by usual prior art method, the pattern comparing inspection method, setting pattern 21 as a standard pattern for the comparison.

The effect of the present invention to the fabrication of the semiconductor die realized in an actual factory is as follows, as compared with the prior art inspection method:

the volume of the store media for the data in the present invention is reduced to as little as one fourth of that in the prior art;

the time spent for designing the inspection data in the present invention is about 80 minutes which reduces the time to less than half of that in the prior art which needed about 3 hours; and

the spent time for the inspection of the semiconductor device in the present invention is about 10 minutes which reduces the time to as little as one fourth of that in the prior art which needed about 40 minutes.

Therefore the effect of the present invention can be said as much as four times in space and time saving, as comapred with the prior art inspection method.

**Claims**

1. An inspection method of a photomask reticle for the fabrication of a semiconductor device having a plurality of patterns comprising the steps of:

firstly numerically comparing the pattern information, obtained from said photomask reticle of one pattern of a group of patterns, which all have a same shape and size, with the corresponding database data which have been used for the fabrication of said photomask reticle; characerised by

then comparing optically the pattern information of the inspected pattern with each of the other patterns of the same group,

whereby all patterns of said photomask reticle are checked.

2. Inspection method according to claim 1 characterized in that prior to the numerical comparison address information of the regions containing the other patterns of said group is determined by designating respective coordinate values.

3. Inspection method according to claim 1 or 2, characterized in that during the database comparison a control unit, which is controlled by a region setter, inactivates the supply of data base information while the camera scans a region which is to be excluded from data base inspection.

4. Inspection method according to claim 3 characterized in that during the data base comparison the control unit, under the control of the region setter, sends a gate signal to the comparator, which gate signal is "off" when the camera scans a region which is to be excluded from data base inspection and which is "on" at all other times.

5. Inspection method according to any of claims 1 to 4 characterized in that during the data base inspection a set of patterns, consisting of one pattern from each group of patterns having a same shape and size, is inspected simultaneously by data base inspection.

6. Apparatus for inspecting a photomask reticle (1) for the fabrication of a semiconductor device comprising a store (9) for data of the different patterns to be inspected, a scanning camera (7), wave shaping circuits (8, 10) for wave shaping information signals from the data store and information signals received from the scanned pattern, a comparator (111), and a control unit (55) characterized in that a region setter (13) is provided for designating address data of regions which are to be excluded from the data base inspection.

7. Apparatus according to claim 6 characterized in that the region setter is designed to send, during data base inspection, control signals to the control unit to send a gating signal to the comparator which gating signal inhibits a comparison when the camera scans a regions which is to be excluded from the data base inspection.

**Patentansprüche**

1. Verfahren zur Untersuchung eines Photomaskenreticles zur Herstellung einer Halbleitervorrichtung mit einer Vielzahl von Mustern, mit den folgenden Schritten:
zuerst numerisches Vergleichen der Musterinformation, welche von dem genannten Photomaskenreticle von einem Muster einer Gruppe von Mustern erhalten wird, welche alle dieselbe Form und Größe haben, mit entsprechenden Datenbankdaten, welche zur Herstellung des genannten Photomaskenreticles verwendet wurden; gekennzeichnet durch
anschließendes optisches Vergleichen der Musterinformation des inspizierten Musters mit jedem der anderen Muster derselben Gruppe,
wodurch alle Muster des genannten Photomaskenreticles geprüft werden.

2. Verfahren nach Anspruch 1, dadurch gekennzeichnet, daß vor dem numerischen Vergleich Adressinformation der Bereiche, welche die anderen Muster der genannten Gruppe enthalten, durch Designieren jeweiliger Koordinatenwerte bestimmt wird.

3. Verfahren nach Anspruch 1 oder 2, dadurch gekennzeichnet, daß während des Datenbankvergleiches eine Steuereinheit, welche von einem Bereichseinsteller gesteuert wird, die Lieferung von Datenbankinformation inaktiviert, während die Kamera einen Bereich überstreicht, der von der Datenbankinspektion ausgenommen werden soll.

4. Verfahren nach Anspruch 3, dadurch gekennzeichnet, daß während des Datenbankvergleiches die Steuereinheit, unter der Steuerung des Bereichseinstellers, ein Torsignal zu einem Komparator sendet, welches Torsignal "Aus" ist, wenn die Kamera einen Bereich überstreicht, der von der Datenbankinspektion ausgeschlossen werden soll, und welches zu allen anderen Zeiten "Ein" ist.

5. Inspektionsverfahren nach einem der Ansprüche 1 bis 4, dadurch gekennzeichnet, daß während der Datenbankinspektion ein Satz von Mustern, der aus einem Muster von jeder Gruppe von Mustern besteht, welche dieselbe Größe und Form haben, gleichzeitig durch Datenbankinspektion inspiziert wird.

6. Verfahren zum Inspizieren eines Photomaskenreticles (1) zur Herstellung einer Halbleitervorrichtung, mit einem Speicher (9) für Daten der verschiedenen zu inspizierenden Muster, einer Abtastkamera (7), Wellenformerschaltungen (8, 10) zur Wellenformung von Informationssignalen von dem Datenspeicher und Informationssignalen, die von dem abgetasteten Muster empfangen werden, einem Komparator (111) und einer Steuereinheit (55), dadurch gekennzeichnet, daß ein Bereichseinsteller (13) zum Designieren der Adreßdaten von Bereichen, welche von der Datenbankinspektion ausgeschlossen werden sollen, vorgesehen ist.

7. Verfahren nach Anspruch 6, dadurch gekennzeichnet, daß der Bereichseinsteller ausgelegt ist, um, während der Datenbankinspektion Steuersignale zu der Steuereinheit zu senden, um ein Torsignal zu dem Komparator zu senden, welches Torsignal einen Vergleich sperrt, wenn die Kamera einen Bereich überstreicht, der von der Datenbankinspektion ausgenommen werden soll.

**Revendications**

1. Méthode d'inspection d'un réticule de photomasque pour la fabrication d'un dispositif à semiconducteur comportant un ensemble de dessins, consistant à:
comparer d'abord numériquement les informations de dessin, obtenues du réticule de photomasque d'un dessin d'un groupe de dessins, ayant tous une même forme et les mêmes dimensions, aux données de base de données correspondantes qui ont été utilisées pour la fabrication du réticule de photomasque;
caractérisée en ce qu'elle consiste à:
comparer ensuite optiquement les informations de dessin du dessin inspecté à chacun des autres dessins du même groupe,
tous les dessins du réticule de photomasque étant de la sorte contrôlés.

2. Méthode d'inspection selon la revendication 1, caractérisée en ce que, avant la comparaison numérique, les informations d'adresse des régions contenant les autres dessins du groupe sont déterminées en indiquant des valeurs de coordonnées respectives.

3. Méthode d'inspection selon l'une quelconque des revendications 1 et 2, caractérisée en ce que, pendant la comparaison avec la base de données, une unité de commande, qui est commandée par un dispositif d'établissement de région, rend inactive la fourniture d'informations de base de données alors que la caméra analyse une région qui doit être exclue de l'inspection à base de données.

4. Méthode d'inspection selon la revendication 3, caractérisée en ce que, pendant la comparaison avec la base de données, l'unité de commande envoie un signal conditionnel au comparateur, sous la commande du dispositif d'établissement de région, ce signal conditionnel étant "absent" quand la caméra analyse une région qui doit être exclue de l'inspection à base de données et "présent" à tout autre moment.

5. Méthode d'inspection selon l'une quelconque des revendications 1 à 4, caractérisée en ce que, pendant l'inspection à base de données, un jeu de dessins, constitué d'un desin de chaque groupe de dessins ayant une même forme et les mêmes dimensions, est inspecté simultanément par l'inspection à base de données.

6. Dispositif pour inspecter un réticule de photomasque (1) pour la fabrication d'un dispositif à semiconducteur comprenant une mémoire (9) pour les données des différents dessins à inspecter, une caméra d'analyse (7), des circuits conformateurs d'onde (8, 10) pour mettre en forme d'onde les signaux d'information provenant de la mémoire de données et les signaux d'information reçus du dessin analysé, un comparateur (111), et une unité de commande (55), caractérisé en ce qu'un dispositif d'établissement de région (13) est prévu pour indiquer les données d'adresse des régions qui doivent être exclues de l'inspection à base de données.

7. Dispositif selon la revendication 6, caractérisé en ce que le dispositif d'établissement de région est conçu pour envoyer, pendant une inspection à base de données, des signaux de commande à l'unité de commande afin d'envoyer un signal conditionnel au comparateur, ce signal conditionnel interdisant une comparaison quand la caméra analyse une région qui doit être exclue de l'inspection à base de données.

FIG.1

FIG.2

FIG.3

FIG.4

# FIG.5

(a)